# EUROPÄISCHE PATENTSCHRIFT

(11) **EP 2 150 856 B1**
(45) Veröffentlichungstag und Bekanntmachung des Hinweises auf die Patenterteilung: **01.08.2012**
(21) Anmeldenummer: 08759892.6
(22) Anmeldetag: 21.05.2008
(51) Int. Cl.: G03F 7/20

(54) **MASK ALIGNER**
MASK ALIGNER
ALIGNEUR DE MASQUES

(30) Priorität: 24.05.2007 DE 102007024122
(43) Veröffentlichungstag der Anmeldung: 10.02.2010
(73) Patentinhaber: Süss MicroTec Lithography GmbH, 85748 Garching (DE)
(72) Erfinder: KAISER, Paul, 81539 München (DE)
(74) Vertreter: Vossius & Partner
(86) Internationale Anmeldenummer: PCT/EP2008/056291
(87) Internationale Veröffentlichungsnummer: WO 2008/142126

(56) Entgegenhaltungen:
- EP-A- 1 174 769
- WO-A-2006/064363
- JP-A- 8 316 123
- JP-A- 53 144 270
- JP-A- 62 247 372
- JP-A- 2000 349 003
- JP-A- 2004 071 782
- US-A- 4 023 904
- US-A1- 2003 015 643
- "Lexikon der Optik", Spektrum Akademidscher Verlag Gmbh, Heidelberg Berlin ISBN: 3-8274-0382-0 vol. 1, pages 360-360,

## Beschreibung

Die vorliegende Erfindung betrifft sogenannte Maskaligner, also Vorrichtungen zum Ausrichten einer Maske zu einem Substrat und anschließendes Belichten, und insbesondere die Belichtungseinrichtung bzw. Belichtungsoptik von Maskalignem.

Vor dem Belichten eines Substrats durch eine Maske und beispielsweise im Rahmen der Fertigung von Halbleiterbauelementen muss zunächst eine Maske in einem geringen, genau definierten Abstand zu einem zu der Maske im wesentlichen parallelen Substrat, das mit einer photosensitiven Schicht (Resist oder Photolack) beschichtet wurde, positioniert bzw. ausgerichtet werden. Meist wird die Maske auch noch bezüglich des Substrats in den beiden in der Maskenebene liegenden Koordinaten sowie in den Rotationsachsen ausgerichtet. Hierbei weisen sowohl die Maske als auch das Substrat Justiermarken auf, deren Position genau bestimmt wird und mit deren Hilfe die Maske bezüglich dem Substrat ausgerichtet werden kann. Die Genauigkeit einer solchen Ausrichtung liegt oft im Bereich von einigen µm, in manchen Anwendungen im sub-µm Bereich.

Nach dem Ausrichten erfolgt die Übertragung der Maskenstrukturen mittels Licht über eine Schattenprojektion in den Photoresist. Die Maske ist typischerweise aus einem transparenten Material, die Strukturen sind lichtundurchlässig. Die Strukturgrößen bis hinab zu wenigen µm können so in den Resist übertragen werden. Nach der Entwicklung des Photoresists, was nicht mehr Aufgabe eines Maskaligners ist, liegt eine mechanische strukturierte Oberfläche für die Weiterverarbeitung wie Ätzen, Beschichten, usw. vor.

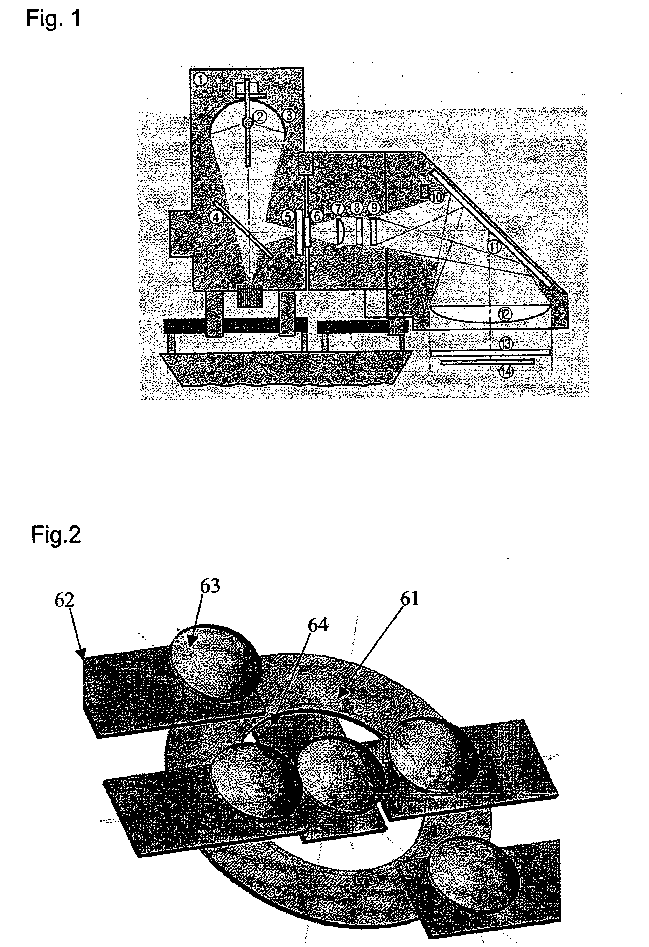

Der typische Aufbau eines herkömmlichen Maskaligners ist in Fig. 1 gezeigt. In dem Maskaligner wird das Substrat 14 zu der Maske 13 ausgerichtet. Die hierzu verwendete Positioniereinrichtung, also beispielsweise ein beweglicher Substratträger (ein sogenannter Chuck) und CCD-Kameras zum Beobachten der auf Maske bzw. Wafer angeordneten Justiermarken sind in der Fig. 1 nicht eingezeichnet. Die Belichtungseinrichtung des Maskaligners weist ein Lampengehäuse 1 auf, in dem sich eine Lichtquelle 2, ein ellipsenförmiger Spiegel 3, ein Kaltlichtspiegel 4 und ein Vorschluss bzw. Shutter 5 befindet. Als Lichtquelle werden im allgemeinen Quecksilber-Dampf oder Quecksilber-Xenon-Dampflampen eingesetzt. Über eine Belichtungsoptik, die möglichst paralleles Licht erzeugt, wird das unter der Maske befindliche Substrat belichtet. Die in der Fig. 1 gezeigte Belichtungsoptik weist ein Linsensystem aus einer Wabenlinse ("Fly's eye") 6, einer Kondensorlinse 7, zwei Linsenplatten 8, 9, einem Spiegel 11 und einer Frontlinse 12.

Die üblicherweise aus Lichtquellen eingesetzten Quecksilberdampflampen weisen eine Leistungsaufnahme zwischen etwa 250 W und 5000 W mit entsprechender UV-Lichtausbeute auf. Das emittierte Spektrum hängt von der Gasfüllung und dem Lampenalter ab und liegt im UV-Bereich zwischen 450 nm und 230 nm. Auf die Spektren der eingesetzten Lampen hin wurden die gängigen Photoresists für Lithografieprozesse optimiert. Um aus dem erzeugten Spektrum bestimmte gewünschte Bereiche auswählen zu können, werden gegebenenfalls Filter eingesetzt. Da, wie oben erwähnt, die UV-Lichtausbeute und das Spektrum unter anderem vom Alter der Lampe abhängen, ist in dem Maskaligner ein UV-Sensor 10 angeordnet, mit dem diese Parameter bestimmt werden können, so dass die der Lampe zugeführte Leistung bzw. die Optik gegebenenfalls angepasst werden kann.

Die üblicherweise eingesetzten Lampen können auch durch UV-LEDs ersetzt werden wie in der DE-U-20 2006 003 924 beschrieben. Belichtungseinrichtungen für Maskaligner sind weiterhin aus der US-A-6 046 793 und der US-A-6 016 185 bekannt.

Ein Maskaligner entsprechend der Präambel des Anspruchs 1 ist aus der US 4 023904 A bekannt.

Die Belichtungseigenschaften eines Maskaligners hängen von einer Reihe von Parametern der Strahlformung ab wie Kollimationswinkel, Strahlkonvergenz, Gleichförmigkeit der Bestrahlung sowie der Belichtungsdauer und der Wellenlängenzusammensetzung. Diese Parameter werden in der Regel durch fest eingebaute optisch wirksame Komponenten wie Blenden, Linsen, Filter eingestellt. Eine Änderung erfordert Umbauten oder Teilewechsler die aufwendig gestaltet sind. Meist ist ein Wirkungsgradverlust noch in Kauf zu nehmen um spezielle Eigenschaften zu erzeugen.

Es ist daher eine Aufgabe der vorliegenden Erfindung, einen Maskaligner bereitzustellen, der die obengenannten Nachteile überwindet.

Diese Aufgaben werden durch die Merkmale der Patentansprüche gelöst.

Die vorliegenden Erfindung basiert auf der Grundidee, in einer Belichtungseinheit für einen Maskaligner eine Lichtquelle, insbesondere eine UV-Lichtquelle, mit einer Kondensoroptik auf einen Verfahrtisch bzw. Scanner anzuordnen. Die Lichtquelle befindet sich bevorzugt etwa in der Brennebene des Kollimators der Belichtungseinrichtung. Durch die Positionierung der Lichtquelle mittels einem mehrachsigem Scanner kann jeder beliebige Kollimationswinkel des Kollimators eingestellt werden. Über die Einschaltdauer der Lichtquelle wird die Gewichtung der unterschiedlichen Kollimationswinkel bei der Gesamtbelichtung definiert. Die Gesamtbelichtung setzt sich zusammen aus der Dosis von unterschiedlichen Strahleigenschaften und Wellenlängen.

Durch die Überlagerung der Strahlen der gleichen Lichtquelle ist die Lichtverteilung gleichmäßiger als durch Aufspaltung einer Lichtquelle in viele Sekundärlichtquellen oder durch eine begrenzte Anzahl von einzelnen UV-LED Lichtquellen. Zusätzlich kann durch Belichtung eines Teils der Belichtungsfläche die Gleichförmigkeit einer Belichtung verbessert werden. Hierzu werden die Abstrahlwinkel der Lichtquelle verkleinert, so daß die Kollimatorlinse nur in einem Bereich ausgeleuchtet wird der dem zu belichtenden Bereich entspricht. Neben der Belichtung mit gleichbleibendem Spektrum kann durch Umschalten der Lichtquelle orts- und zeitabhängig die Strahlcharakteristik auch noch mittels Spektrum moduliert werden. Über eine schnelle Regelung der Lichtquellenleistung kann außerdem die Belichtung gezielt intensitätsmoduliert werden.

Eine Teilflächenbelichtungen der Maske kann mittels Ausblenden nicht gewünschter Abstrahlwinkel erfolgen. Effizienter ist dies durch eine veränderbare Kondensoroptik zu erreichen zumal das Intensitätsprofil dann rotationssymmetrisch bleibt. Zusätzlich kann die Lichtquelle mit dazugehöriger Kondensoroptik um 2 Achsen geschwenkt werden, um die gleichen Kollimationswinkel auf den Teilflächen zu erreichen. Die Kondensoroptik kann einen Lichthomogenisator aufweisen, der beispielsweise aus Mikrolinsen aufgebaut ist. Durch gezielte Positionierung der Lichtquelle außerhalb der Kollimatorbrennebene kann bei Abstandsbelichtungen ferner der Run Out beeinflusst werden. Dies kann rotationssymmetrisch oder nach einem frei wählbaren Profil geschehen. So würde beispielsweise die Maskenschattenprojektion-Abstandsbelichtung bei einer Lichtquellenposition weiter als die Kollimatorbrennweite durch die dann leicht fokussierende Wirkung der Kollimatorlinse geringfügig verkleinert ausfallen.

Das Bewegungsprofil eines beispielsweise 5-achsigen Scanners mit den dazugehörigen Einschaltdauer bzw. Intensitäten sowie Wellenlängen kann als Prozessparameter-Datei gespeichert werden und bei nachfolgenden Belichtungen reproduziert werden. Durch sehr einfaches Verstellen dieser Parameter (Zeit und Position) kann ein Belichtungsprozess einfach optimiert werden.

Als Lichtquellen können Festkörperlichquellen (SSDs; Solid State Device) wie UV-LEDs und UV-Laser verwendet werden, wie sie von NORLUX / NICHIA / OSRAM bekannt sind. Auch kann dieses Licht aus Lichtleitern stammen, in die UV-Licht aus SSDs oder UV-Lampen eingespeist wurde. Entscheidend ist, daß die Lichtquellen bzw. die Lichtleiterenden geeignet sind, mittels Scanner schnell und einfach auf die benötigten Positionen gefahren zu werden. Werden mehrere Lichtquellen zu einem Array zusammengefasst, ist eine möglichst enge Packung für die nachgeschaltete Kondensoroptik vorteilhaft.

Den Lichtquellen nachgeschaltet ist eine ebenfalls mitfahrende Kondensoroptik, die das Licht der einzelnen SSDs oder Lichtleiterausgänge möglichst effizient dem Kollimator anpasst. Die Kondensoroptik kann so eingestellt werden, daß die Lichtquelle die Kollimatorlinse vollständig oder nur teilweise ausgeleuchtet. Zur Effizienzsteigerung ist der Kollimator typischerweise mit einer Feldlinse direkt hinter dem Scanner ausgestattet.

Die Lichtquellen werden je nach Bauform und Anwendung flüssigkeitsgekühlt oder luftgekühlt. Werden Schläuche bzw. Lichtleiter an den Scanner herangeführt, sind diese sehr flexibel ausgeführt. Bei Scannern mit einer Rotationsachse dreht sich die Scanner-Lichtquelle nicht mit, sondern führt lediglich eine Translation aus.

Die einfachste Bauform mit maximaler Flexibilität ist eine einzige Lichtquelle auf einem 5-achsigen Tisch mit 3 orthogonalen Translationsachsen und 2 Rotationsachsen. Für z.B. hohe Leistungen ohne Teilflächenbelichtung können mehrere UV-Lichtquellen zu einem Array mit einer gemeinsamen Kondensoroptik ausgestattet werden. Mehrere davon werden an einem 3-achsigen Scanner angebracht, um, gleichzeitig überlagert, mehrere Kollimationswinkel auf der gesamten Belichtungsfläche bereit zu stellen. Ein zusätzlicher Teilflächenbelichtungsscanner kann nach Platzwechsel mit der Lichtquelle, die zuvor den größten Teil der Belichtungsdosis übertragen hat, oder Positionierung zwischen Lichtquelle und Kollimator, nachträglich die Belichtungsgleichmäßigkeit verbessern. Die Lichtquelle kann ein Kollimationswinkelscanner aber auch eine konventionelle UV-Lichtquelle sein.

Um den Maskaligner zum Einsatz bei verschiedenen Wellenlängen vorzubereiten, weist der Maskaligner vorzugsweise Vorrichtungen auf, die es ermöglichen, die SSD-UV-Lichtquellen schnell und einfach wechseln zu können. Dies kann beispielsweise durch geeignete Anschläge geschehen. UV-Lichtquellen können in verschiedenen Ausführungsformen bereitgestellt werden. Daneben können auch UV-Lichtquellen mit unterschiedlichem Spektrum innerhalb einer Scanner-Lichtquelle und innerhalb eines Scanners angeordnet sein.

Zur Überprüfung der UV-Lichtquellenparameter wie z.B. Intensität oder Spektrum kann die Lichtquelle Referenzpunkte anfahren, die außerhalb des Nutzbereichs für die Belichtung liegen. Durch geeignete Sensorik werden die Lichtquellen charakterisiert und z.B. deren Parametersatz bei automatischen Systemen aktualisiert.

Die erfmdungsgemäße Belichtungsvorrichtung kann einerseits im Dauerbetrieb betrieben werden, beispielsweise für den Einsatz in der Produktion. Hierzu ist eine kontinuierliche Kühlung notwendig, die typischerweise mit einer Kühlflüssigkeit durchgeführt wird. Durch die besonderen Eigenschaften der S SD-UV-Lichtquelle kann jedoch auch ein Pulsbetrieb mit entsprechenden Abkühlphasen mit oder ohne aktive Kühlung durchgeführt werden. Dies ist möglich, da für eine stabile, gleichförmige Beleuchtung keine langen Aufwärmzeiten notwendig sind. Der Pulsbetrieb ist besonders beim Einsatz im Labor interessant. Insgesamt weist das Belichtungssystem gemäß der vorliegenden Erfindung die Vorteile auf, daß die für die Abbildungseigenschaften eines Maskaligners wichtigen Parameter wie Kollimationswinkel, Lichtverteilung, Intensität, spektrale Zusammensetzung individuell und frei konfigurierbar eingestellt werden können. Bei Verwendung von SSDs ist eine hohe Langzeitstabilität gewährleistet, die eine automatische Charakterisierung der Lichtquelle erleichtert. Einmal ermittelte Belichtungsprofile bleiben mit SSDs ebenfalls langzeitstabil. Damit ist eine gezielte Belichtungs-Parameteroptimierung möglich. Eine vorherige Simulation am Rechner mit entsprechenden Modellen wird somit auch sinnvoll und erspart bis auf die Feinabstimmung aufwendige Versuchsbelichtungen.

Die Erfindung wird im folgenden unter Bezugnahme auf die beliegenden Zeichnungen näher erläutert.
Fig. 1 zeigt den schematischen Aufbau eines herkömmlichen Maskaligners;
Fig. 2 zeigt systematisch einen SSD-Scanner gemäß einer Ausführungsform der Erfindung, ausgeführt mit einer rotierenden Linearachse.
Fig. 3 zeigt die Anordnung eines Kollimationswinkelscanners in Verbindung mit einem Kollimator.
Fig. 4 zeigt eine Vergrößerung des Kollimationswinkelscanners von Fig. 3 mit Teilflächenbelichtungseinstellung.
Fig. 5 zeigt die Teilflächenbelichtung am Rand des Belichtungsfeldes.
Fig. 6 illustriert die Run Out-Kompensation
Fig. 7 zeigt eine Kondensoroptik mit Wabenlinsenplatten gemäß einer Ausführungsform der Erfindung.

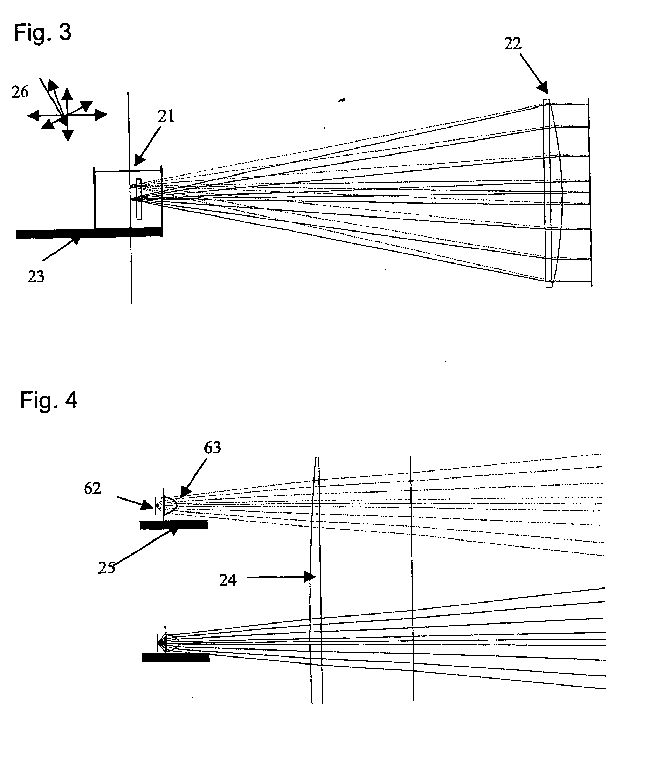

In Fig. 2 ist systematisch ein SSD-Scanner gezeigt. In der in Fig. 2 gezeigten Ausführungsform der vorliegenden Erfindung ist der Scanner mit einer rotierenden Linearachse 61 ausgeführt. Die SSD 62 mit vorgeschalteter Optik 63 ist in mehreren Positionen dargestellt, wobei diese sich nicht verdreht. Eine Drehlagerung zwischen Linearachse und SSD-Aufnahme stellt dies sicher. Je nach Abstand zur Rotationsachse ergibt sich in Verbindung mit dem in Fig. 3 dargestellten Kollimator ein frei wählbarer Kollimationswinkel in der Belichtungsebene. Die Linearachse erlaubt der SSD auch das Anfahren der Rotationsmitte, so daß die gesamte Fläche abgescannt werden kann.

Die gleiche Funktion kann auch mit einem Scanner mit zwei gekreuzten Linearachsen erreicht werden. Eine Drehlagerung zwischen SSD und Linearachse ist dann unnötig. Auf der Rotationsmitte kann auch eine SSD 64 mit vorgeschalteter Optik stationär angebracht sein und dem Scanner vor oder nachgelagert sein, so daß beide sich in ihrer Funktion nicht behindern. Die stabile Winkelausrichtung der SSD im Raum ist wichtig um eine verdrillfreie Stromversorgung über elektrische Leitungen einfach zu gestalten. Bei Verwendung von Lichtleitern wie z.B. Glasfaserlichtleiter an Stelle der auf dem Scanner befestigten SSD ist so auch eine einfache optische Verbindung zur eigentlichen Lichtquelle am anderen Ende des Lichtleiters möglich.

Weiterhin ist eine paarweise Anordnung der SSDs dargestellt. Damit kann gleichzeitig die doppelte Lichtintensität in den Kollimator eingekoppelt werden. Auf der gleichen Linearführung wird der Abstand zur Rotationsachse mit zwei Antrieben symmetrisch eingestellt, um bei schnellen Drehungen eine Unwucht zu vermeiden. Prinzipiell ist aber auch eine unabhängige Bewegung, beispielsweise bei geringen Winkelgeschwindigkeiten möglich. Analog können auch mehrere SSDs mit vorgeschalteter Optik in einem festen oder fest einstellbaren Abstand auf den Linearachsen befestigt sein. Gleiches gilt für die Ausführung mit Lichtleitern an Stelle der SSDs.

Fig. 3 zeigt die Anordnung des Kollimationswinkelscanner 21 mit allen Bewegungsrichtungen 26 in Verbindung mit einem Kollimator 22. Der Kollimationswinkelscanner 21 ist auf einer Linearachse 23 parallel zur optischen Achse des Kollimators angeordnet. Damit lässt sich die Kollimation einstellen, aber auch bewusst eine leichte Fokussierung oder Divergenz der belichtenden Strahlen. Außerdem kann der

Kollimationswinkelscanner weit zurück gezogen werden, um Positionen für zusätzliche Messtechnik komfortabel zu erreichen.

Der Verfahrbereich orthogonal zur optischen Achse ist so dimensioniert, daß zusätzliche Messeinrichtungen z.B. zur Kalibrierung der Lichtquellen erreicht werden können. In Fig. 3 sind zwei Positionen der in einer Richtung verfahrenen Lichtquelle und die sich daraus ergebenen unterschiedlichen Kollimationswinkel in der Belichtungsebene bzw. Maskenebene 13 dargestellt.

Fig. 4 stellt die zwei Scannerpositionen aus Fig. 3 vergrößert dar. Zusätzlich ist hier eine Linearverstellmöglichkeit 25 zu erkennen, mit der die Kondensoroptik 63 z.B. eine asphärische Linse gegenüber der Lichtquelle 62 so verstellt werden kann, daß sich die ausgeleuchtete Fläche des Kollimators 22 und damit die ausgeleuchtete Fläche auf der Maske 13 ändert. Dem Kollimationswinkelscanner nachgeschaltet ist hier die Feldlinse 24 der Kollimatoroptik.

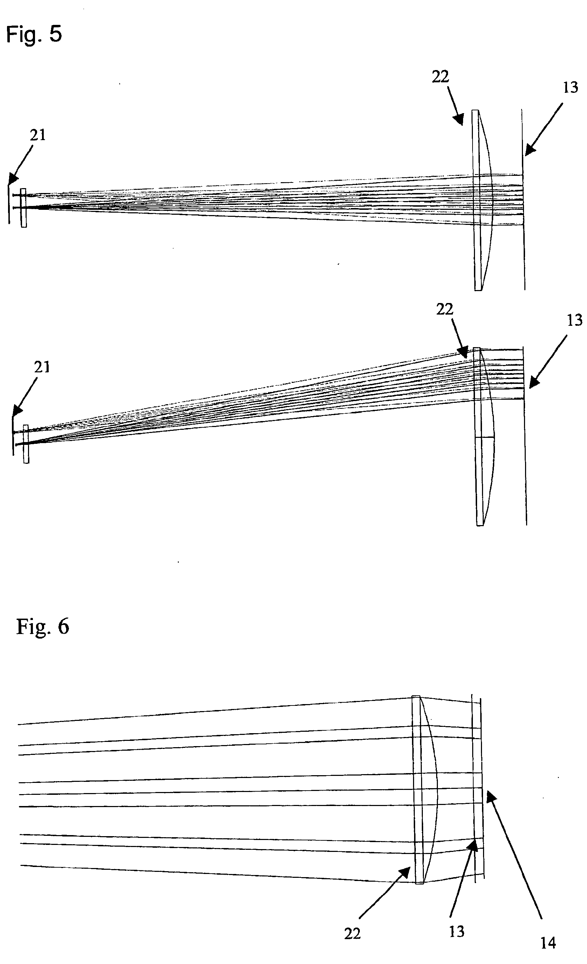

Fig. 5 zeigt die Teilflächenbelichtung am Rand des Belichtungsfeldes. Dazu ist die Lichtquelle mit der dazu gehörenden Kondensoroptik zusätzlich um 2 Achsen schwenkbar. Die Schwenkung kann individuell für jede Lichtquelle als auch über die Scanner-Achsen wie hier an einer Achse dargestellt erfolgen.

Fig. 6 zeigt die sog. Run Out-Kompensation. Durch bewusst leicht fokussierende Kollimation, der Kollimationswinkelscanner ist in einem Abstand größer ist als die Kollimatorbrennweite angeordnet, wird bei einer Abstandsbelichtung der Schattenwurf auf das zu belichtende Substrat 14 der Maske 13 verkleinert. Umgekehrtes gilt für Abstände die kleiner sind als die Kollimatorbrennweite. Die notwendigen Abstände werden durch die Achse parallel zur Kollimatorachse z.B. motorisch eingestellt.

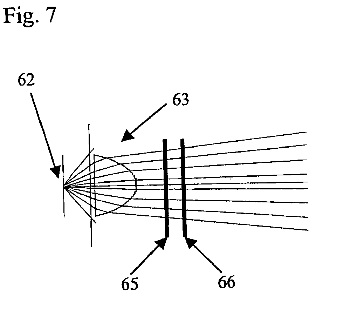

Fig. 7 zeigt eine Kondensoroptik 63 mit einem Lichthomogenisator aus 2 Wabenlinsenplatten 65 und 66 zur Homogenisierung der Ausleuchtung. Das zur Hauptachse mittels der Kondensoroptik 63 möglichst kollimierte Licht der Lichtquelle 62 wird mit jeder Linse der Wabenlinsenplatte 65 in eben so viele sekundäre Lichtquellen wie Wabenlinsen abgebildet, die dann ihrerseits mit dem Kollimator 22 auf der Maske 13 überlagert werden.

Im Fokus der Wabenlinsen der Wabenlinsenplatte 65 befindet sich die Wabenlinsenplatte 66 deren Einzellinsen als einzelne Feldlinsen fungieren. Um eine möglichst gute Homogenität zu erreichen, werden möglichst viele und damit kleine Linsen in der jeweiligen Linsenplatte dicht nebeneinander angeordnet. Dieses Prinzip kann insbesondere mit Mikrolinsen realisiert werden, um für die beweglichen Optiken möglichst viele Linsenpaare bereitzustellen. Die Linsenpaare können aus 2 Linsenplatten oder aus einer beidseitig strukturierten Glasplatte hergestellt werden. Im letzteren Fall ist es beispielsweise möglich, eine Quarzplatte mit bekannten Verfahren beidseitig mit sphärischen oder asphärischen Linsenflächen hexagonal gepackt strukturiert herzustellen. Auf einen Quadratmillimeter sind so beispielsweise etwa 100 Linsenflächen herstellbar.

## Patentansprüche

1. Maskaligner für eine Belichtung mittels Schattenprojektion mit
einer Positioniereinrichtung zum Ausrichten eines Substrats (14) bezüglich einer Maske (13) und
einer Belichtungseinrichtung, die eine Lichtquelle (62) und einen Kollimator (22) aufweist **dadurch gekennzeichnet, dass**
die Lichtquelle (62) zusammen mit einer Kondensoroptik (63) zur ausleuschtung des Kollimators auf einem mehrachsigen Verfahrtisch angeordnet ist.

2. Maskaligner gemäß Anspruch 1, wobei die Lichtquelle (62) in der Brennebene des Kollimators (22) angeordnet ist und in einer Ebene orthogonal zu dessen Hauptachse entsprechend eines gewünschten Kollimationswinkels mittels dem Verfahrtisch verfahrbar ist.

3. Maskaligner gemäß Anspruch 2, wobei der Verfahrtisch, zwei orthogonal gekreuzte Achsen aufweist.

4. Maskaligner nach Anspruch 2, wobei der Verfahrtisch eine Translationsachse mit Rotationsachse aufweist.

5. Maskaligner gemäß Anspruch 4, wobei die um die Hauptachse des Kollimators (22) rotierende Lichtquelle (62) dazu eingerichtet ist, nur eine Translationsbewegung und keine Rotationsbewegung auszuführen.

6. Maskaligner gemäß einem der vorstehenden Ansprüche, wobei der Verfahrtisch auf einer Achse parallel zur Hauptachse des Kollimators (22) in einem Bereich vor und hinter dem Brennpunkt des Kollimator (22) verfahrbar ist.

7. Maskaligner gemäß Anspruch 6, ferner mit einer Kollimatorfeldlinse, die zwischen der Lichtquelle (62) mit der Kondensoroptik (63) und den Kollimator (22) angeordnet ist und mit der Lichtquelle (62) in Richtung der Hauptachse des Kollimator (22) verfahren wird.

8. Maskaligner gemäß Anspruch 1 und 2, wobei die Lichtquelle (62) mit der Kondensoroptik (63) zusätzlich auf einem Winkelscanner angeordnet ist, der für Ablenkung bis 10° geeignet ist.

9. Maskaligner gemäß einem der vorstehenden Ansprüche, wobei die Kondensoroptik (63) bezüglich der Lichtquelle (62) entlang der Hauptachse der Kondensoroptik (63) verfahren werden kann.

10. Maskaligner gemäß einem der vorstehenden Ansprüche, wobei die Kondensoroptik (63) ferner einen Lichthomogenisator (65, 66) aufweist.

11. Maskaligner gemäß dem Anspruch 10, wobei der Lichthomogenisator (65, 66) Mikrolinsen aufweist.

12. Maskaligner gemäß dem Anspruch 10 oder 11, wobei der Lichthomogenisator (65, 66) eine Glasplatte mit beidseitig paarweise gegenüber liegenden Linsenflächen, die gegenseitig im Brennpunkt stehen, aufweist.

13. Maskaligner gemäß einem der vorstehenden Ansprüche, wobei die Lichtquelle (62) eine derartige Bauform hat, dass sie geeignet ist, einfach von einem handelsüblichen mehrachsigen Kreuztisch bewegt zu werden.

14. Maskaligner gemäß einem der vorstehenden Ansprüche, wobei die Lichtquelle (62) eine Festkörperlichtquelle ist.

15. Maskaligner gemäß Anspruch 14, wobei die Lichtquelle (62) eine LED oder ein Halbleiter-Laser ist.

16. Maskaligner gemäß einem der Ansprüche 1 bis 12, wobei die Lichtquelle (62) ein Lichtleiter ist, in den Licht eingekoppelt wird.

17. Maskaligner gemäß Anspruch 16, wobei Licht in den Lichtleiter aus einer thermischen Lichtquelle aus einer oder mehreren Festkörperlichtquellen oder einem Laser eingekoppelt wird.

18. Maskaligner gemäß einem der vorstehenden Ansprüche, wobei die Lichtquelle (62) ein dicht gepacktes Array einzelner Lichtquellen aufweist.

19. Maskaligner gemäß einem der vorstehenden Ansprüche, wobei die Lichtquelle (62) im Bereich 230nm - 450nm emittiert.

20. Maskaligner gemäß einem der vorstehenden Ansprüche, wobei die Lichtquelle (62) Einzellichtquellen mit jeweils unterschiedlichem Spektrum aufweist.

21. Maskaligner gemäß Anspruch 20, wobei die Lichtquelle (62) Filter zum Abstrahlen unterschiedlicher Spektren aufweist.

22. Maskaligner gemäß Anspruch 20 oder 21, wobei die spektrale Konfiguration der Lichtquelle (62) abgespeichert werden kann und später reproduziert werden kann.

23. Maskaligner gemäß einem der vorstehenden Ansprüche, wobei eine Messeinrichtung zur Referenzierung der Lichtquelle (62) mit dem mehrachsigen Tisch angefahren werden kann.

24. Maskaligner gemäß einem der vorstehenden Ansprüche, wobei die Verfahrtischpositionen und Verfahrgeschwindigkeiten mit den dazu gehörigen Lichteinstellungen wie Spektrum und Einschaltdauer mit einem Rechner aufgezeichnet werden und später reproduziert werden können.

25. Verfahren zur Belichtung eines Substrats (14) durch eine Maske (13) mit einem Maskaligner gemäß einem der Ansprüche 1 bis 24 wobei die Belichtungskollimationswinkel nach Wert und Bauer eingestellt werden.

26. Verfahren zur Belichtung eines Substrats (14) durch eine Maske (13) mit einem Maskaligner gemäß einem der Ansprüche 1 bis 24 wobei die Belichtungsintensitätsverteilung durch Teilflächenbelichtung eingestellt wird.

27. Verfahren zur Belichtung eines Substrats (14) durch eine Maske (13) mit einem Maskaligner gemäß einem der Ansprüche 1 bis 24, Run Out bei Abstandsschattenprojektionen durch Defokussierung der Kollimatoroptik (22) eingestellt wird.

28. Verfahren zur Belichtung eines Substrats (14) durch eine Maske (13) mit einem Maskaligner gemäß einem der Ansprüche 1 bis 24, wobei Belichtungsspektrum und -zeit eingestellt werden.

29. Verfahren zur Belichtung eines Substrats (14) durch eine Maske (13) mit einem Maskaligner gemäß einem der Ansprüche 1 bis 24, die Verfahren der Ansprüche 25 - 29 teilweise oder vollständig gleichzeitig zum Einsatz kommen.

## Claims

1. A mask aligner for an illumination by means of shadow projection comprising:
positioning means for aligning a substrate (14) relative to a mask (13) and
illumination means comprising a light source (62) and a collimator (22), **characterized in that**
the light source (62) is arranged together with condenser optics (63) for illuminating the collimator on a movable multi-axis table.

2. The mask aligner according to claim 1, wherein the light source (62) is arranged in the focal plane of the collimator (22) and can be moved by means of the movable table in a plane orthogonal with respect to its main axis in accordance with a desired collimator angle.

3. The mask aligner according to claim 2, wherein the movable table comprises two orthogonally crossed axes.

4. The mask aligner according to claim 2, wherein the movable table comprises a translation axis with rotational axis.

5. The mask aligner according to claim 4, wherein the light source (62) rotating about the main axis of the collimator (22) is adapted to perform only a translatory motion and no rotational motion.

6. The mask aligner according to any one of the preceding claims, wherein the movable table can be moved on an axis parallel to the main axis of the collimator (22) in an area before and behind the focal point of the collimator (22).

7. The mask aligner according to claim 6, further comprising a collimator field lens which is arranged between the light source (62) with the condenser optics (63) and the collimator (22) and moved together with the light source (62) in the direction of the main axis of the collimator (22).

8. The mask aligner according to claims 1 and 2, wherein the light source (62) with the condenser optics (63) is additionally arranged on an angle scanner suitable for a deflection up to 10°.

9. The mask aligner according to any one of the preceding claims, wherein the condenser optics (63) can be moved relative to the light source (62) along the main axis of the condenser optics (63).

10. The mask aligner according to any one of the preceding claims, wherein the condenser optics (63) further comprise a light homogenizer (65, 66).

11. The mask aligner according to claim 10, wherein the light homogenizer (65, 66) comprises microlenses.

12. The mask aligner according to claim 10 or 11, wherein the light homogenizer (65, 66) comprises a glass plate with lens surfaces opposing each other in pairs on both sides and being mutually in the focus.

13. The mask aligner according to any one of the preceding claims, wherein the light source (62) has such a structure that it is suitable for being moved easily by a commercially available multi-axis cross table.

14. The mask aligner according to any one of the preceding claims, wherein the light source (62) is a solid-state light source.

15. The mask aligner according to claim 14, wherein the light source (62) is an LED or a semiconductor laser.

16. The mask aligner according to any one of claims 1 to 12, wherein the light source (62) is a light conductor in which light is coupled in.

17. The mask aligner according to claim 16, wherein light is coupled into the light conductor from a thermal light source from one or more solid-state light source(s) or a laser.

18. The mask aligner according to any one of the preceding claims, wherein the light source (62) comprises a densely packed array of individual light sources.

19. The mask aligner according to any one of the preceding claims, wherein the light source (62) emits in the range of 230 nm to 450 nm.

20. The mask aligner according to any one of the preceding claims, wherein the light source (62) comprises single light sources each having a different spectrum.

21. The mask aligner according to claim 20, wherein the light source (62) comprises filters for irradiating different spectra.

22. The mask aligner according to claim 20 or 21, wherein the spectral configuration of the light source (62) can be stored and reproduced later.

23. The mask aligner according to any one of the preceding claims, wherein a measuring means for referencing the light source (62) can be approached by means of the multi-axis table.

24. The mask aligner according to any one of the preceding claims, wherein the positions of the movable table and the moving speeds with the corresponding light adjustments such as spectra and power-on duration can be recorded by means of a computer and reproduced later.

25. A method for illuminating a substrate (14) through a mask (13) comprising a mask aligner according to any one of claims 1 to 24, wherein the illumination collimation angles are adjusted in accordance with the value and duration.

26. A method for illuminating a substrate (14) through a mask (13) comprising a mask aligner according to any one of claims 1 to 24, wherein the illumination intensity distribution is adjusted by partial surface illumination.

27. A method for illuminating a substrate (14) through a mask (13) comprising a mask aligner according to any one of claims 1 to 24, wherein the run out in distance shadow projections is adjusted by defocusing the collimator optics (22).

28. A method for illuminating a substrate (14) through a mask (13) comprising a mask aligner according to any one of claims 1 to 24, wherein illumination spectrum and illumination time are adjusted.

29. A method for illuminating a substrate (14) through a mask (13) comprising a mask aligner according to any one of claims 1 to 24, wherein the methods of claims 25 to 29 are used partially or completely simultaneously.

## Revendications

1. Aligneur de masques destiné à l'insolation par projection d'ombre avec un dispositif de positionnement pour l'alignement d'un substrat (14) par rapport à un masque (13) et un dispositif d'insolation comportant une source lumineuse (62) et un collimateur (22), **caractérisé en ce que** la source lumineuse (62) est disposée sur une table de déplacement multiaxiale avec une optique de condensateur (63) pour l'éclairage du collimateur.

2. Aligneur de masques selon la revendication 1, où la source lumineuse (62) est disposée sur le plan focal du collimateur (22) et est déplaçable au moyen de la table de déplacement sur un plan orthogonal à l'axe principal du collimateur, suivant un angle de collimation souhaité.

3. Aligneur de masques selon la revendication 2, où la table de déplacement présente deux axes à intersection orthogonale.

4. Aligneur de masques selon la revendication 2, où la table de déplacement présente un axe de translation avec un axe de rotation.

5. Aligneur de masques selon la revendication 4, où la source lumineuse (62) rotative autour de l'axe principal du collimateur (22) est prévue pour n'effectuer qu'un mouvement de translation, et aucun mouvement de rotation.

6. Aligneur de masques selon l'une des revendications précédentes, où la table de déplacement est déplaçable sur un axe parallèlement à l'axe principal du collimateur (22) dans une zone devant et derrière le point focal du collimateur (22).

7. Aligneur de masques selon la revendication 6, comportant en outre une lentille de champ de collimateur, disposée entre la source lumineuse (62) avec l'optique de condensateur (63) et le collimateur (22), et déplacée avec la source lumineuse (62) dans la direction de l'axe principal du collimateur (22).

8. Aligneur de masques selon les revendications 1 et 2, où la source lumineuse (62) avec l'optique de condensateur (63) est en outre disposée sur un scanner angulaire, approprié pour une déflexion jusqu'à 10°.

9. Aligneur de masques selon l'une des revendications précédentes, où l'optique de condensateur (63) peut être déplacée par rapport à la source lumineuse (62) le long de l'axe principal de l'optique de condensateur (63).

10. Aligneur de masques selon l'une des revendications précédentes, où l'optique de condensateur (63) comporte en outre un homogénéiseur de lumière (65, 66).

11. Aligneur de masques selon la revendication 10, où l'homogénéiseur de lumière (65, 66) comporte des micro-lentilles.

12. Aligneur de masques selon la revendication 10 ou la revendication 11, où l'homogénéiseur de lumière (65, 66) comporte une plaque en verre avec des surfaces de lentilles opposées par paires de part et d'autre et situées bilatéralement sur le point focal.

13. Aligneur de masques selon l'une des revendications précédentes, où la source lumineuse (62) présente une construction telle qu'elle est apte à n'être déplacée que par une table multiaxiale à mouvements croisés du commerce.

14. Aligneur de masques selon l'une des revendications précédentes, où la source lumineuse (62) est une source lumineuse solide.

15. Aligneur de masques selon la revendication 14, où la source lumineuse (62) est une diode électroluminescente ou un laser semi-conducteur.

16. Aligneur de masques selon l'une des revendications 1 à 12, où la source lumineuse (62) est un conducteur de lumière auquel la lumière est couplée.

17. Aligneur de masques selon la revendication 16, où la lumière dans le conducteur de lumière est couplée depuis une source lumineuse thermique, depuis une ou plusieurs sources lumineuses solides ou depuis un laser.

18. Aligneur de masques selon l'une des revendications précédentes, où la source lumineuse (62) présente un réseau dense de sources lumineuses distinctes.

19. Aligneur de masques selon l'une des revendications précédentes, où la source lumineuse (62) émet dans une plage de 230 nm à 450 nm.

20. Aligneur de masques selon l'une des revendications précédentes, où la source lumineuse (62) comporte des sources lumineuses distinctes ayant chacune un spectre différent.

21. Aligneur de masques selon la revendication 20, où la source lumineuse (62) comporte des filtres pour la diffusion de spectres différents.

22. Aligneur de masques selon la revendication 20 ou la revendication 21, où la configuration spectrale de la source lumineuse (62) peut être mémorisée et reproduite ultérieurement.

23. Aligneur de masques selon l'une des revendications précédentes, où un dispositif de mesure pour le référencement de la source lumineuse (62) peut être déplacé avec la table multiaxiale.

24. Aligneur de masques selon l'une des revendications précédentes, où les positions de la table de déplacement et les vitesses de déplacement sont enregistrées par un ordinateur avec les réglages lumineux correspondants tels que spectre et durée d'activation, et peuvent être reproduites ultérieurement.

25. Procédé d'insolation d'un substrat (14) par un masque (13) avec un aligneur de masques selon l'une des revendications 1 à 24, les angles de collimation d'insolation sont réglés en valeur et en durée.

26. Procédé d'insolation d'un substrat (14) par un masque (13) avec un aligneur de masques selon l'une des revendications 1 à 24, où la répartition d'intensité d'insolation est réglée par insolation de surfaces partielles.

27. Procédé d'insolation d'un substrat (14) par un masque (13) avec un aligneur de masques selon l'une des revendications 1 à 24, où le run-out lors des projections d'ombres portées est réglé par défocalisation de l'optique de collimateur (22).

28. Procédé d'insolation d'un substrat (14) par un masque (13) avec un aligneur de masques selon l'une des revendications 1 à 24, où le spectre et le temps d'insolation sont réglés.

29. Procédé d'insolation d'un substrat (14) par un masque (13) avec un aligneur de masques selon l'une des revendications 1 à 24, où les procédés des revendications 25 à 29 sont mis en oeuvre simultanément, en tout ou en partie.
